# EUROPÄISCHE PATENTSCHRIFT

(11) **EP 0 986 292 B1**
(45) Veröffentlichungstag und Bekanntmachung des Hinweises auf die Patenterteilung: **19.04.2006**
(21) Anmeldenummer: 99112642.6
(22) Anmeldetag: 02.07.1999
(51) Int. Cl.: H05K 7/20

(54) **Wärmeleitende Einlegematte für elektrische und elektronische Geräte**
Thermal transfer mat for electrical or electronic apparatuses
Coussin pour transférer la chaleur, appliqué aux appareils électriques et électroniques

(30) Priorität: 09.09.1998 DE 19841037; 24.09.1998 DE 29817185 U
(43) Veröffentlichungstag der Anmeldung: 15.03.2000
(73) Patentinhaber: Patent-Treuhand-Gesellschaft für elektrische Glühlampen mbH, 81543 München (DE)
(72) Erfinder: Huber, Andreas, 82216 Maisach (DE); Forster, Franz, 85614 Kirchseeon (DE); Niedermeier, Peter, 80995 München (DE); Limmer, Walter, 80801 München (DE)

(56) Entgegenhaltungen:
- GB-A- 2 229 041
- US-A- 4 654 754
- US-A- 5 161 092

## Beschreibung

### Technisches Gebiet

Die Erfindung betrifft eine wärmeleitende Einlegematte für elektrische und elektronische Geräte gemäß dem Oberbegriff des Anspruchs 1. Bei diesen Geräten handelt sich insbesondere um Betriebsgeräte für Hochdruckentladungslampen, aber auch für Halogenglühlampen und Niederdruckentladungslampen. Weitere Anwendungen sind Audio- und Videogeräte, Dimmgeräte sowie diverse Leistungselektronikgeräte, beispielsweise für die Motorensteuerung. Charakteristisch ist die in den Geräten auftretende relativ hohe Verlustleistung, bedingt durch hohe Ströme in der ungefähren Größenordnung von weniger als 1 A bis zu mehr als 50 A.
Die beim Betrieb von elektronischen und elektrischen Geräten entstehende Verlustleistung wird in Wärme umgesetzt. Sie entsteht im Innern des Gerätes und muß nach außen abgeführt werden. Vor allem bei Geräten mit geschlossenen Gehäusen muß die Verlustwärme durch Wärmeleitung von der Wärmequelle im Innern des Gerätes möglichst effektiv an die Gerätewand weitergeleitet werden und von dort an die Umgebung abgegeben werden. Die Wärmequelle ist dabei ein oder meist mehrere elektrische oder insbesondere elektronische Bauteile, wobei besonders letztere sehr empfindlich gegen Überhitzung sind. Meist sind die Bauteile auf einer Platine montiert. Bei vielen oberflächenmontierten Bauteilen mit unterschiedlicher Bauhöhe ist eine direkte Kontaktierung mit einem Kühlkörper oder einer Kühlfahne nicht gewährleistet.

### Stand der Technik

Aus der US-A 4 654 754 ist eine wärmeleitende Einlegematte bekannt, die als Material Metall verwendet. Eine alternative Ausführungsform ist dort eine elektrisch isolierende Matte, insbesondere ein elastomeres Material, das mit thermisch leitenden Partikeln gefüllt ist, so dass eine Matte oder ein Blatt mit einer Vielzahl von erhabenen Abschnitten entsteht mit jeweils einem luftgefüllten Zwischenraum dazwischen.

Bisher wurde zur Vermeidung von Wärmestaus in elektrischen Geräten folgendes Prinzip verwendet: Die Geräte werden zumindest teilweise mit einer gut wärmeleitenden Vergußmasse vergossen. Aus der Schrift EP-A 645 944 ist beispielsweise ein Betriebsgerät für elektrische Lampen bekannt, bei der die Wärmeabfuhr durch eine wärmeleitende Vergußmasse erfolgt. Durch diese Masse wird die Wärme an die Gehäusewände weitergeleitet und kann dort an die Umgebung abgegeben werden.

### Darstellung der Erfindung

Es ist Aufgabe der vorliegenden Erfindung, eine wärmeleitende Einlegematte für elektrische und elektronische Geräte gemäß dem Oberbegriff des Anspruchs 1 bereitzustellen, mit deren Hilfe sich die Wärmeableitung bei diesen Geräten auf besonders einfache Art und Weise bewerkstelligen läßt.

Diese Aufgabe wird durch die kennzeichnenden Merkmale des Anspruchs 1 gelöst. Besonders vorteilhafte Ausgestaltungen finden sich in den abhängigen Ansprüchen.

Die wärmeleitende Einlegematte für elektrische und elektronische Geräte hat einen Grundkörper von einfacher flächiger Geometrie, wobei eine Unterseite für den Kontakt zur Außenwand des Gerätes und eine Oberseite des Grundkörpers für den Kontakt zur Wärmequelle im Innern des Gerätes bestimmt ist. Bevorzugt ist die Oberseite mit einer höhenausgleichenden Struktur ausgestattet, während die Unterseite glatt sein kann. Als Material eignet sich ein Material mit geringer Schohrhärte von höchstens 15. In einer besonders bevorzugten Ausführungsform wird modifiziertes Kohlenwasserstoffharz oder Silikonverbundfolie verwendet.

Durch den Einbau der neu entwickelten Matte ist es möglich, die Verlustwärme bei derartigen Geräten besonders zuverlässig und effektiv von der Wärmequelle an eine äußere Gerätewand weiterzuleiten. Beispielsweise ist die Wärmequelle ein elektronisches Bauteil auf einer Platine. Wenn die Matte (Mindestdicke 1 mm) zwischen Platine und Gerätewand eingelegt wird, ist es möglich, die Verlustwärme über die Platinenunterseite abzuführen und an die Gerätewand, insbesondere eine Bodenplatte weiterzuleiten, ohne daß auf die Position von elektronischen Bauteilen, beispielsweise SMD-Bauteilen, auf der Platinenunterseite Rücksicht genommen werden muß. Vorteilhaft besitzt die Matte eine spezielle Struktur der den elektrischen oder elektronischen Bauteilen zugewandten Oberfläche, die den Ausgleich unterschiedlicher Höhen von verschiedenen Bauteilen ermöglicht. Gut geeignet sind beispielsweise erhabene Lamellen, die parallel zueinander angeordnet sind. Typisch ermöglicht eine derartige Matte den Ausgleich von ca. 3 mm, ohne daß ihre wärmeableitende Funktion beeinträchtigt wird. Diese Einlegematte besteht bevorzugt aus elektrisch isolierendem Material wie Kunststoff oder Keramik, insbesondere Kunstharz wie modifiziertem Kohlenwasserstoffharz, beispielsweise der Fa. Paul Jordan (Guronic-FR), oder Silikonverbundfolien, beispielsweise der Fa. Kunze Folien (KU-TKC oder KU-TKM), die mit Keramik gefüllt sind um die Wärmeleitung noch zu erhöhen. Matten aus homogenem Kunstharz sind verformbar, biegsam und weisen eine weiche sowie klebrige Konsistenz auf und können eine hohe elektrische Isolation besitzen. Die genannten Materialien sind in beliebige Formen gießbar und können somit leicht den gewünschten Anforderungen an die Form entsprechen.

Diese Matte besitzt eine einfache geometrische Form (beispielsweise rechteckig) und wird in ihrer Dicke zweckmäßig auf den Abstand zwischen Wärmequelle und Gerätewand dimensioniert, beispielsweise zwischen Platine und Bodenplatte eines Gerätes. Gut praktikabel ist eine Dicke von 1 bis 10 mm. Vor allem das Material Kunstharz ist weich und nachgebend. Eine höhenausgleichende Struktur an mindestens einer Oberfläche ermöglicht den guten Wärmekontakt auch bei unterschiedlicher Bauhöhe verschiedener elektronischer Bauteile.

Vorteilhaft besitzt die Matte auf mindestens der der Platine zugewandten Oberseite erhabene Lamellen, die genügend Platz für die Aufnahme von Vorsprüngen an den elektronischen Bauteile belassen. Gut geeignet ist ein rechteckiger oder trapezförmiger Querschnitt der Lamellen. Die Basisbreite und der Abstand der Lamellen sollte in etwa in derselben Größenordnung (Faktor 1:2 bis 2:1) liegen. Der Abstand ebenso wie die Höhe der Lamellen liegt bevorzugt zwischen 1 und 8 mm. Diese Bemessung sorgt für einen guten Wärmekontakt der gängigen elektronischen Bauelemente, die in etwa dieselbe Größenordnung besitzen.

Besondere Vorteile gegenüber einer Vergußmasse liegen darin, daß die Möglichkeit besteht, das Gerät wieder zu öffnen, daß die mechanische Belastung durch unterschiedliche Wärmeausdehnungskoeffizienten geringer ist und daß der Materialverbrauch geringer ist. Die Dicke der Einlegematte ist so dimensioniert, daß die Einlegematte in möglichst gutem Kontakt mit der Wärmequelle steht (insbesondere ist dies die Platinenunterseite).

Weitere Vorteile bestehen darin, daß die verbesserte Wärmeableitung der mit der Einlegematte bestückten Geräte deren Einsatzbereich auch auf thermisch hochbelastete Umgebungen ausdehnt. Beispielsweise gilt dies für Betriebsgeräte elektrischer Lampen, die nun auch für thermisch ungünstige Leuchtenkonstruktionen tauglich sind. Derartige Geräte sind außerdem leichter recyclingfähig und werden den Auflagen der Elektronikschrottverordnung besser gerecht. Zudem ist jetzt eine Nachbearbeitung dieser Geräte während der Fertigung möglich.

Es können auch mehrere Einlegematten in einem elektronischen Gerät verwendet werden. Beispielsweise ist dies dann angezeigt, wenn mehrere elektronische Platinen im Gerät verwendet werden, die unterschiedlich orientiert sind.

### Figuren

Im folgenden soll die Erfindung anhand eines Ausführungsbeispiels näher erläutert werden. Es zeigen:
- Figur 1: eine Einlegematte in Draufsicht (Figur 1a), im Längsschnitt (Figur 1b) und im Querschnitt (Figur 1c)
- Figur 2: ein Betriebsgerät für eine Entladungslampe in Seitenansicht, teilweise aufgeschnitten
- Figur 3: das Betriebsgerät aus Figur 2 mit abgenommenem Oberteil

### Beschreibung der Zeichnungen

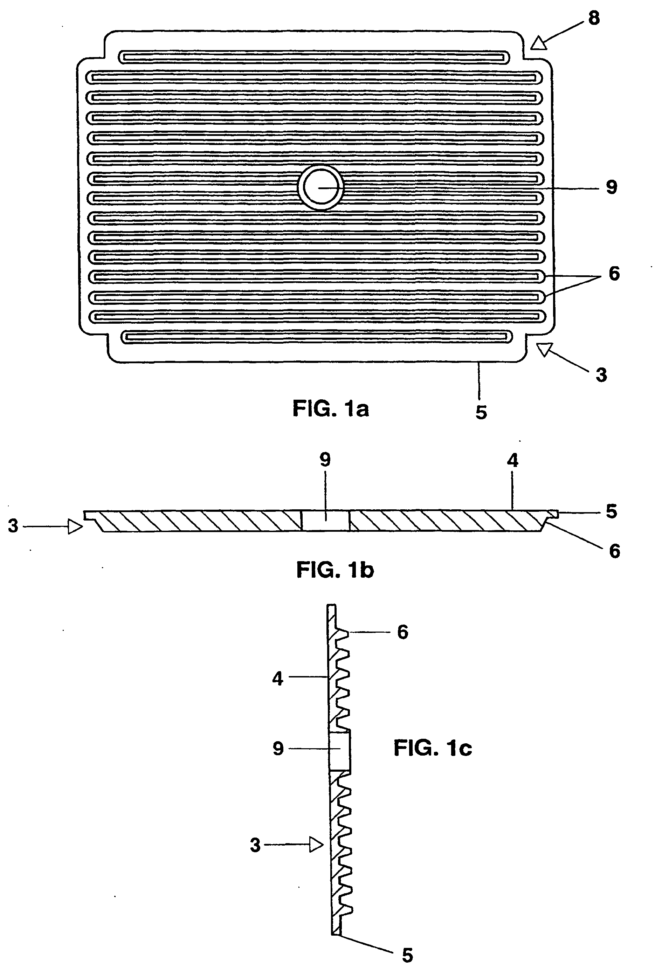

Fig. 1 zeigt eine in etwa rechteckige Einlegematte 3 mit einer Länge von 11 cm, einer Breite von 7,5 cm und einer gesamten Dicke von 4,5 mm. Auf einem Grundkörper 5 von 2 mm Dicke sind an der der Wärmequelle zugewandten Oberseite längsgerichtete zueinander parallele Lamellen 6 mit rechteckigem Querschnitt mit einer Höhe von 2,5 mm und etwa 1 mm Breite aufgebracht. Die Unterseite 4 ist glatt und schafft damit einen optimalen Wärmekontakt zur Gerätewand. Die Lamellen 6 sind jeweils etwa 3 mm voneinander beabstandet. Insgesamt ergibt sich dadurch eine im Querschnitt (Figur 1c) sägezahnartige oder mäanderförmige Struktur. An ihren vier Ecken besitzt die Matte 3 Einkerbungen 8 und außerdem ein zentrales Loch 9, die die Halterung und Orientierung der Matte 3 im Gerät erleichtern oder Aussparungen für Befestigungsmittel bilden. Die Matte besteht aus modifiziertem Kohlenwasserstoffharz, das der Matte klebrige Eigenschaften an ihrer Oberfläche verleiht. Die Schohrhärte A beträgt 10. Die Matte besitzt daher eine sehr gute Haftung an der Bodenplatte und einen sehr guten Wärmekontakt zur Platine.

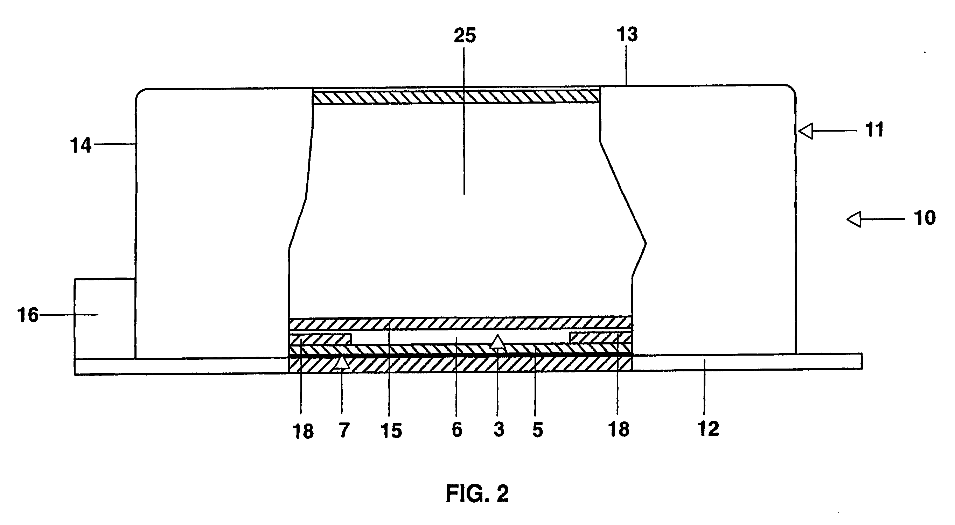

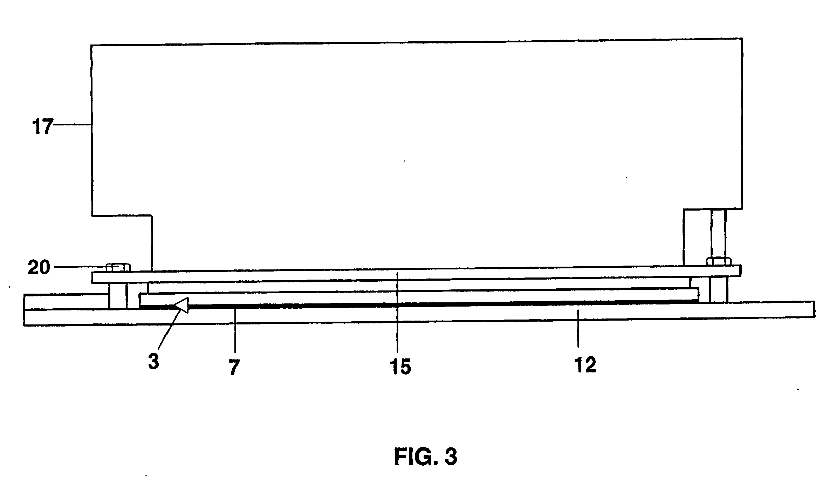

Durch eine zusätzliche Folie 7 (siehe Figur 2 und 3) aus Kunststoff (Hostafen), die zwischen Matte und Bodenplatte angeordnet wird, kann die elektrische Isolation zwischen Platine und Bodenteil auch für den unwahrscheinlichen Fall eines Durchstichs eines Bauteils oder einer Stromzuführung durch die Matte zur Gerätewand hin garantiert werden. Bei einer Stärke der Folie 7 von 0,1 mm ergibt sich im eingebauten Zustand somit eine Gesamtdicke von 4,6 mm.

Als Ausführungsbeispiel eines elektronischen Geräts ist in Figur 2 ein Betriebsgerät für eine Hochdruckentladungslampe gezeigt. Dafür wird ein EVG (elektronisches Vorschaltgerät) 10 verwendet mit einem Gehäuse aus Kunststoff und Metall. Dieses ist gegliedert in eine metallische Bodenplatte 12 aus Aluminium und ein Oberteil 11 aus Kunststoff, bestehend aus einem Deckel 13 mit angesetzten Seitenwänden 14. Eine vom Gehäuse umschlossene liegende elektronische Platine 15 (gestrichelt eingezeichnet), auf der die elektronischen Bauteile (nicht gezeigt) montiert sind, ist an der Bodenplatte 12 mittels Schrauben 20 befestigt. Im Innenraum 25 des Gehäuses ist außerdem eine hochkant stehende Platine (nicht sichtbar) montiert. Zwischen Platine 15 und Bodenplatte 12 ist eine gut wärmeleitende Einlegematte 3 eingelegt. An einer der Seitenwände befindet sich ein Anschlußteil 16, das mit der Bodenplatte 12 verschraubt ist und das zum elektrischen Anschluß der Lampe an das Betriebsgerät sowie zur Spannungsversorgung des Betriebsgeräts dient.

Nach Befestigung der Montageplatine 15 einschließlich der darauf angeordnetem elektronischen und elektrischen Bauteile auf der Bodenplatte 12 wird das Oberteil 11 auf die Bodenplatte 12 aufgesetzt und mittels einer Schnappverbindung 18 an der Platine 15 arretiert. Die Abmessungen der Matte 3 sind etwas kleiner als die der Platine 15, so daß keine besondere Aussparung an der Matte 3 für den am Außenrand der Platine befindlichen Schnappmechanismus vorgesehen werden muß.

In Fig. 3 ist das EVG ohne umhüllenden Deckel bzw. Seitenwand gezeigt. Das EVG besitzt neben der liegenden Platine 15 auch eine hochkant gestellte Platine 17. Der Abstand der liegenden Platine 15 zur Bodenplatte 12 beträgt 4,5 mm. Somit ist immer ein wärmeleitender Kontakt der Einlegematte 3 sowohl zur Platine 15 wie auch zur Bodenplatte 12 hin garantiert.

Die Geometrie der Matte ist an die Geometrie der Bodenplatte angepaßt. Eine weitere derartige Matte kann auch zwischen der hochkant gestellten Platine 17 und der benachbarten Seitenwand eingebracht werden.

Ein Vergleich mit einem baugleichen Betriebsgerät, das jedoch konventionell mit Vergußmasse ausgestattet war, ergab eine wesentliche Verbesserung der maximal zulässigen Umgebungstemperatur der Leuchte um 15 °C. Während bisherige Leuchten nur eine Umgebungstemperatur von 25 °C tolerierten, kann jetzt eine Belastung bis 40 °C erfolgen.

## Patentansprüche

1. Wärmeleitende Einlegematte (3) für elektrische und elektronische Geräte, mit einem Grundkörper (5) von einfacher flächiger Geometrie, wobei eine Unterseite (4) des Grundkörpers für den Kontakt zur Außenwand des Gerätes und eine Oberseite des Grundkörpers für den Kontakt zur Wärmequelle im Innern des Gerätes bestimmt ist, wobei die Matte elektrisch isolierend ist und aus Material besteht, das ausgewählt ist aus der Gruppe Kunststoff oder Keramik oder Silikonverbundfolie, die mit Keramik gefüllt ist, und wobei die Matte (3) eine klebrige Oberfläche besitzt.

2. Einlegematte nach Anspruch 1, **dadurch gekennzeichnet, daß** die Matte (3) aus modifiziertem Kohlenwasserstoffharz besteht.

3. Einlegematte nach Anspruch 1, **dadurch gekennzeichnet, daß** die Matte (3) homogen aus Kunstharz besteht.

4. Einlegematte nach Anspruch 1, **dadurch gekennzeichnet, daß** die Matte (3) eine Dicke von mindestens 1 mm besitzt.

5. Einlegematte nach Anspruch 1, **dadurch gekennzeichnet, daß** die Unterseite (4) glatt ist, während die Oberseite eine höhenausgleichende Struktur besitzt.

6. Einlegematte nach Anspruch 5, **dadurch gekennzeichnet, daß** die höhenausgleichende Struktur aus erhabenen Lamellen (6) besteht.

7. Elektrisches oder elektronisches Gerät (10), bestehend aus einem Gehäuse mit Wandteilen (12,13,14) und aus darin angebrachten elektrischen und/oder elektronischen Bauteilen, die als Wärmequelle wirken, **dadurch gekennzeichnet, daß** zwischen der Wärmequelle und einem benachbarten Wandteil des Gehäuses eine wärmeleitende Matte (3) nach einem der vorhergehenden Ansprüche eingebracht ist.

8. Gerät nach Anspruch 7, **dadurch gekennzeichnet, daß** die Bauteile mindestens teilweise auf einer Platine (15) montiert sind.

9. Gerät nach Anspruch 7, **dadurch gekennzeichnet, daß** zusätzlich eine Folie (7) mit hoher elektrischer Isolation zwischen Matte (3) und benachbartem Wandteil (12) eingebracht ist.

10. Gerät nach Anspruch 7, **dadurch gekennzeichnet, daß** das benachbarte Wandteil, das insbesondere die Bodenplatte (12) ist, selbst gut wärmeleitend ist und insbesondere aus Metall besteht.

## Claims

1. Thermally conductive inlay mat (3) for electrical and electronic appliances, having a base body (5) of simple sheet-like geometry, an underside (4) of the base body being intended to be in contact with the outer wall of the appliance and a top side of the base body being intended to be in contact with the heat source inside the appliance, the mat being electrically insulating and consisting of material selected from the group consisting of plastic or ceramic or silicone composite sheet which is filled with ceramic, and the mat (3) having a sticky surface.

2. Inlay mat according to Claim 1, **characterized in that** the mat (3) comprises modified hydrocarbon resin.

3. Inlay mat according to Claim 1, **characterized in that** the mat (3) homogeneously comprises synthetic resin.

4. Inlay mat according to Claim 1, **characterized in that** the thickness of the mat (3) is at least 1 mm.

5. Inlay mat according to Claim 1, **characterized in that** the underside (4) is smooth, while the top side has a height-compensating structure.

6. Inlay mat according to Claim 5, **characterized in that** the height-compensating structure comprises raised lamellae (6).

7. Electrical or electronic appliance (10), comprising a housing with wall parts (12, 13, 14) and electrical and/or electronic components which are arranged therein and act as a heat source, **characterized in that** a thermally conductive mat (3) according to one of the preceding claims is inserted between the heat source and an adjoining wall part of the housing.

8. Appliance according to Claim 7, **characterized in that** at least some of the components are mounted on a circuit board.

9. Appliance according to Claim 7, **characterized in that** a film (7) with a high degree of electrical insulation is additionally inserted between mat (3) and adjoining wall part (12).

10. Appliance according to Claim 7, **characterized in that** the adjoining wall part, which is in particular the base plate (12), itself has good thermal conductivity and comprises in particular metal.

## Revendications

1. Coussin (3) d'insertion, conducteur de la chaleur, pour des appareils électriques et électroniques, comprenant une embase (5) d'une géométrie plate (5), une face (4) inférieure de l'embase étant destinée au contact avec la paroi extérieure de l'appareil et une face supérieure de l'embase au contact avec la source de chaleur à l'intérieur de l'appareil, le coussin étant isolant électriquement et étant en un matériau qui est choisi dans le groupe des matières plastiques ou des céramiques ou d'une feuille composite en silicium, qui est chargée de céramique, le coussin (3) ayant une surface collante.

2. Coussin d'insertion suivant la revendication 1, **caractérisé en ce que** le coussin (3) est en une résine hydrocarbonée modifiée.

3. Coussin d'insertion suivant la revendication 1, **caractérisé en ce que** le coussin (3) est d'une manière homogène en une résine synthétique.

4. Coussin d'insertion suivant la revendication 1, **caractérisé en ce que** le coussin (3) a une épaisseur d'au moins 1 mm.

5. Coussin d'insertion suivant la revendication 1, **caractérisé en ce que** la face (4) inférieure est lisse, tandis que la face supérieure a une structure de compensation de niveau.

6. Coussin d'insertion suivant la revendication 5, **caractérisé en ce que** la structure de compensation de niveau est constituée de lamelles (6) en saillie.

7. Appareil (10) électrique ou électronique, constitué d'un boîtier ayant des parties (12, 13, 14) de paroi et de composants électriques et/ou électroniques qui y sont montés et qui agissent en tant que source de chaleur, **caractérisé en ce qu'**il est introduit, entre la source de chaleur et une partie de paroi voisine du boîtier, un coussin(3) conducteur de la chaleur suivant l'une des revendications précédentes.

8. Appareil suivant la revendication 7, **caractérisé en ce que** les composants sont montés au moins en partie sur une platine (15).

9. Appareil suivant la revendication 7, **caractérisé en ce qu'**en outre une feuille (7) ayant un bon isolant électrique est introduite entre le coussin (3) et la partie de paroi voisine.

10. Appareil électrique suivant la revendication 7, **caractérisé en ce que** la partie de paroi voisine, qui est notamment la plaque (12) de fond, conduit soi-même très bien la chaleur et est notamment en métal.
